# EUROPÄISCHE PATENTANMELDUNG

(11) **EP 1 589 560 A1**
(43) Veröffentlichungstag der Anmeldung: **26.10.2005**
(21) Anmeldenummer: 05101354.8
(22) Anmeldetag: 23.02.2005
(51) Int. Cl.: H01J 37/141

(54) **Objektivlinse für einen geladenen Partikelstrahl**

(30) Priorität: 23.04.2004 DE 102004019833
(71) Anmelder: Leica Microsystems Lithography GmbH, 07745 Jena (DE)
(72) Erfinder: Elster, Thomas, Dr., 07745 Jena (DE); Hahmann, Peter, Dr., 07751 Jena-Drackendorf (DE); Kirschstein, Ulf-Carsten, 07751 Jenapriessnitz (DE); Krauhs, Dorothee, 07747 Jena (DE); Fortagne, Andre, 07768 Kahla (DE)
(74) Vertreter: Reichert, Werner Franz

(57) **Zusammenfassung**

Es ist eine Objektivlinse (2) für einen geladenen Partikelstrahl offenbart. Das Objektivlinsensystem (20) der Objektivlinse (2) besteht aus einer Linsenwicklung (21) und einem Eisenkreis (22), wobei der Eisenkreis (22) einen unteren Polschuh (25) trägt, der konisch ausgebildet ist und gegenüber einer Oberfläche (6a) des Wafers (6) vorgesehen ist. Ein Stützzylinder (23) umgibt das Objektivlinsensystem (20), wobei sein unterer Teil ein Messsystem (24) zur Bestimmung der Höhenlage der Oberfläche (6a) des Wafers (6) umfasst.

## Beschreibung

Die Erfindung betrifft eine Objektivlinse für einen geladenen Partikelstrahl. Im besonderen betrifft die Erfindung eine Objektivlinse für einen geladenen Partikelstrahl, wobei ein Ablenksystem vorgesehen ist, das von einem Objektivlinsensystem umgeben ist, wobei das Objektivlinsensystem aus einer Linsenwicklung und einem Eisenkreis besteht, dass der Eisenkreis einen unteren Polschuh trägt, der konisch ausgebildet ist und gegenüber einer Oberfläche des Wafers vorgesehen ist, und dass ein Stützzylinder das Objektivlinsensystem umgibt.

Die europäische Patentschrift EP 0 870 316 B1 offenbart eine mehrteilige magnetische Linse mit konzentrischen Spalten und einer Ablenkeinheit mit konischen Polschuhen. Die Linse ist axialsymmetrisch ausgebildet und die konische Geometrie des unteren Teils der Linse verlängert auf vorteilhafte Weise, dass das magnetische Linsenfeld nahe an das Substrat gebracht werden kann. Dennoch hat die Linse keine Einrichtung vorgesehen, mit der auch eine Höhenmessung des Substrat durchgeführt werden kann.

Die deutsche Patenschrift EP 0 641 001 B1 offenbart ein Elektronenstrahlgerät, bei dem die Objektivlinse eine Kontrolleinheit umfasst, mit der die Höhe des Substrats am Auftreffort des Elektronenstrahls gemessen wird. Die Objektivlinse ist nicht konisch ausgebildet und ist im wesentlichen gegenüber dem Substrat parallel ausgebildet.

Der Erfindung liegt die Aufgabe zugrunde eine Objektivlinse für einen Partikelstrahl aus geladenen Teilchen derart auszugestalten, dass die chromatische Aberration und die sphärische Aberration im Bereich der Oberfläche des Substrats reduziert sind und gleichzeitig die Messung der Höhenlage des Wafers ermöglicht ist. Somit soll auch die Auflösung des elektronenoptischen Systems verbessert und variabel ausgestaltet sein.

Diese Aufgabe wird durch ein System mit den Merkmalen des Anspruchs 1 gelöst.

Es ist von besonderen Vorteil, dass der Stützzylinder einen unteren Abschnitt ausgebildet hat, der der Oberfläche des Wafers gegenüber liegt, und dass der untere Abschnitt ein Messsystem zur Bestimmung der Höhenlage der Oberfläche des Wafers trägt.

Das Messsystem ist ein optisches Messsystem ist. Das Messsystem umfasst einen Sender und einen Empfänger, wobei der Sender und der Empfänger jeweils mit einem optischen Umlenkmittel versehen sind. Das optische Umlenkmittel ist derart ausgestaltet, dass ein Auftreffpunkt des Laserstrahls der Höhenmessung mit einer elektronenoptischen Achse im Bereich der Oberfläche des Wafers zusammentrifft. Der Laserstrahl schließt mit der Oberfläche des Wafers einen Winkel zwischen 10° und 30°ein. Bevorzugt ist ein Winkel von 20°.

Es ist ferner von Vorteil, wenn der untere Teil des Stützzylinders als Temperierplatte ausgebildet ist, die den Partikelstrahl konzentrisch umgibt. Somit kann man durch Heizen oder Kühlen den Wafer bzw. Das Substrat auf einer konstanten Temperatur halten.

Die erfindungsgemäße Objektivlinse findet in einer Elektronenstrahllithographiemaschine Verwendung.

Weitere vorteilhafte Ausgestaltungen können den Unteransprüchen entnommen werden.

In der Zeichnung ist der Erfindungsgegenstand schematisch dargestellt und wird anhand der Figuren nachfolgend beschrieben. Dabei zeigen:
- Fig. 1: eine schematische Darstellung des Aufbaus einer gesamten Elektronenstrahlsäule;
- Fig. 2a: den Achsfeldverlauf der magnetischen Feldstärke einer Objektivlinse nach dem Stand der Technik;
- Fig. 2b: den Achsfeldverlauf der magnetischen Feldstärke einer Objektivlinse mit einer großen Bohrung für den Durchtritt des geladenen Partikelstrahls;
- Fig. 2c: den Achsfeldverlauf der magnetischen Feldstärke einer Objektivlinse gemäß der Erfindung mit einem konischen Polschuh und einer kleinen Bohrung für den Durchtritt des Elektronenstrahls;
- Fig. 3: eine Detailansicht der Ausgestaltung einer erfindungsgemäßen Objektivlinse;
- Fig. 4: eine Detailansicht einer Ausführungsform der Objektivlinse, bei der die Abdichtung durch eine am unteren Polschuh vorgesehenes Element erfolgt; und
- Fig. 5: eine Detailansicht der Anordnung der Objektivlinse mit dem Messsystem zur Bestimmung der Höhenlage der Oberfläche eines Wafers.

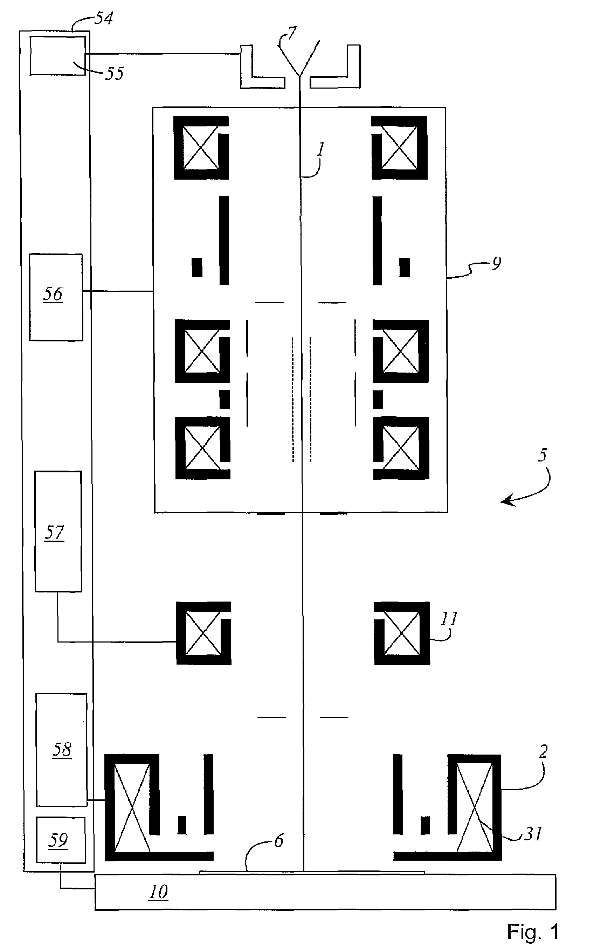

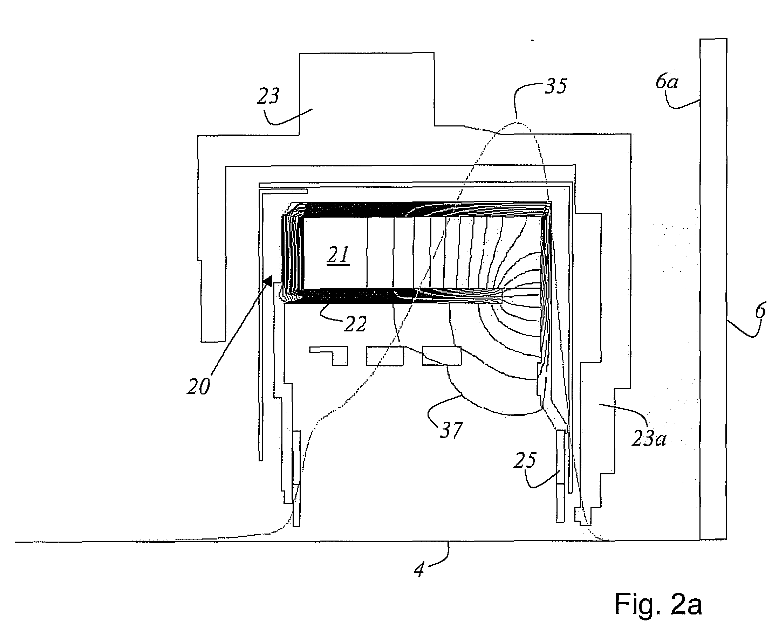

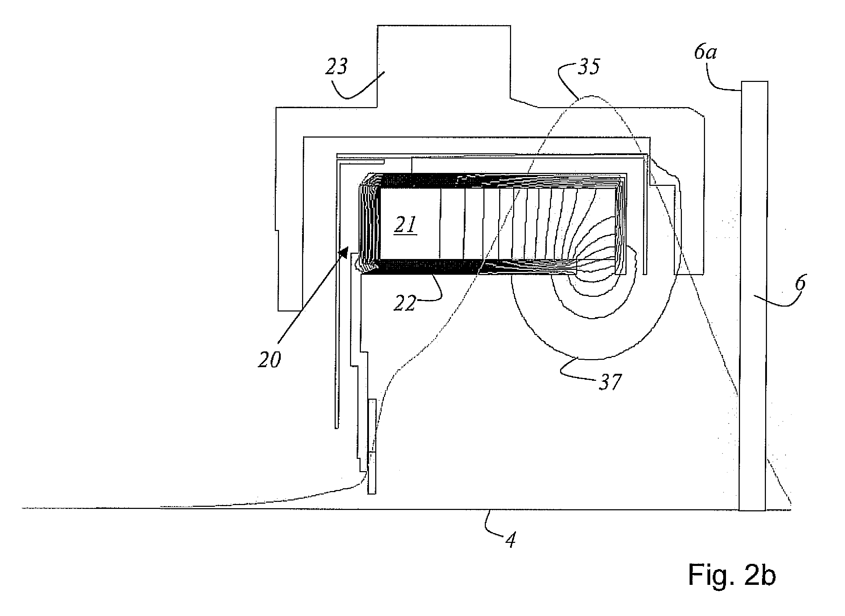

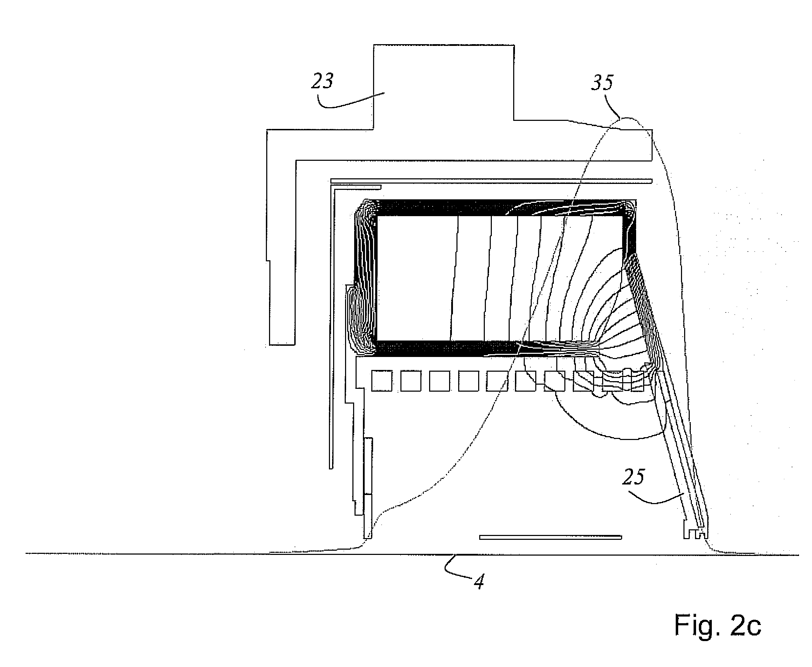

Fig. 1 zeigt. veranschaulicht die Struktur einer Elektronenstrahlsäule 5, in der ein Elektronenstrahl 1 von einer eine Strahlquelle bildenden Elektronenkanone 7 erzeugt wird, wobei er durch ein Kondensorsystem 9, mindestens eine Verkleinerungslinse 11 zur Objektivlinse 2 und demgemäß zum Halbleitersubstrat bzw. den Wafer 6 hindurch läuft. Obwohl sich die nachstehende Beschreibung auf Elektronenstrahlen beschränkt, ist es einem Fachmann klar, dass auch alle anderen Teilchenstrahlen mit geladenen Partikeln hier Anwendung finden. Die Anordnung verfügt über ein Steuerungssystem 54. Die Elektronenkanone 7 wird von einer Quellensteuerung 55 gesteuert, und der Strahl wird unter Steuerung einer Kondensorsteuerung 56 durch das Kondensorsystem 9 gebündelt. Die mindestens eine Verkleinerungslinse 11 wird über eine Linsensteuerung 57 gesteuert. Die Objektivlinse 2 wird über eine Objektivlinsen-Steuerung 58 gesteuert. Der Tisch 10 wird über eine Tischsteuerung 59 geregelt und gesteuert und in einer Ebene verfahren, um verschiedene Positionen auf der Oberfläche 6a des Wafers 6 in den Elektronenstrahl 1 zu verfahren. Die Objektivlinse 2 ist mit einem Ablenksystem 12 versehen, das den Elektronenstrahl auf der Oberfläche 6a des Wafers 6 auslenkt. Die Höhenunterschiede des Wafers 6 werden mittels der Objektivlinse 2 kompensiert. Eine Kompensation derartiger Höhenunterschiede des Wafers 6 wird dadurch erzielt, dass der Treiberstrom für die Erregerspule 31 der Objektivlinse 2 eingestellt wird. Wie in der folgenden Beschreibung beschrieben, umfasst die Objektivlinse 2 ein Messsystem (siehe Fig. 2), mit dem die Höhenunterschiede des Wafers 6 gemessen werden. Aufgrund der Messung erfolgt eine Nachregelung, so dass der Elektronenstrahl 1 immer auf die Oberfläche 6a des Wafers 6 fokussiert ist.

Für begrenzte Abrasterbereiche kann das Abrastern durch das Ablenksystem 12 erzielt werden. Für größere Bewegungen sorgt die Tischsteuerung 59 dafür, dass der Tisch 10, und damit der Wafer 6, horizontal verstellt oder verfahren wird.

Fig. 2a zeigt den Achsfeldverlauf der magnetischen Feldstärke 35 einer Objektivlinse 2 nach dem Stand der Technik. In den Darstellung der Fig. 2a, Fig. 2b und Fig. 2c ist lediglich die Hälfte der Objektivlinse 2 dargestellt. Die Objektivlinse 2 ist um die elektronenoptische Achse 4 rotationssymmetrisch. Das Objektivlinsensystem 20 umfasst eine Linsenwicklung 21 und einen Eisenkreis 22, in dem die Magnetfeldlinien 37 geführt sind. Der Strahl aus geladenen Partikeln breitet sich in Richtung der elektronenoptischen Achse 4 aus und trifft beim Austritt aus der Objektivlinse 2 auf die Oberfläche 6a des Wafers 6. Der untere Polschuh 25 des Eisenkreis 22 ist nicht konisch ausgebildet und der untere Teil 23a des Stützzylinders 23 besitzt den gleichen Abstand von der elektronenoptischen Achse 4 wie der untere Polschuh 25. Die magnetische Feldstärke fällt zwar unmittelbar nach der Objektivlinse 2 auf ein Minimum ab, dennoch kann der Wafer 6 aufgrund der Ausgestaltung des unteren Teils 23a des Stützzylinders 23 nicht optimal wenig von der Objektivlinse 2 beabstandet sein.

Fig. 2b zeigt den Achsfeldverlauf der magnetischen Feldstärke 35 einer Objektivlinse 2 mit einer großen Bohrung für den Durchtritt des geladenen Partikelstrahls. Die magnetische Feldstärke 35 Fällt nach dem Durchgang durch die Objektivlinse 2 zu langsam auf den Wert Null ab, dass bei einem optimal von der Objektivlinse 2 beabstandeten Wafer auf der Oberfläche 6a des Wafers 6 immer noch eine gewisser Wert der magnetischen Feldstärke 35 vorherrscht. Ein Wert der magnetischen Feldstärke 35 an der Oberfläche 6a des Wafers 6 stört die Schreibeigenschaften des Partikelstrahls aus geladenen Teilchen.

Fig. 2c zeigt den Achsfeldverlauf der magnetischen Feldstärke einer Objektivlinse 2 gemäß der Erfindung mit einem konischen unteren Polschuh 25 und einer kleinen Bohrung für den Durchtritt des Elektronenstrahls. Die magnetische Feldstärke 35 fällt schnell auf den Wert Null ab. Aufgrund der mechanischen Ausgestaltung des Polschuhes 25 kann der Wafer 6 optimal von der Objektivlinse 2 beabstandet werden.

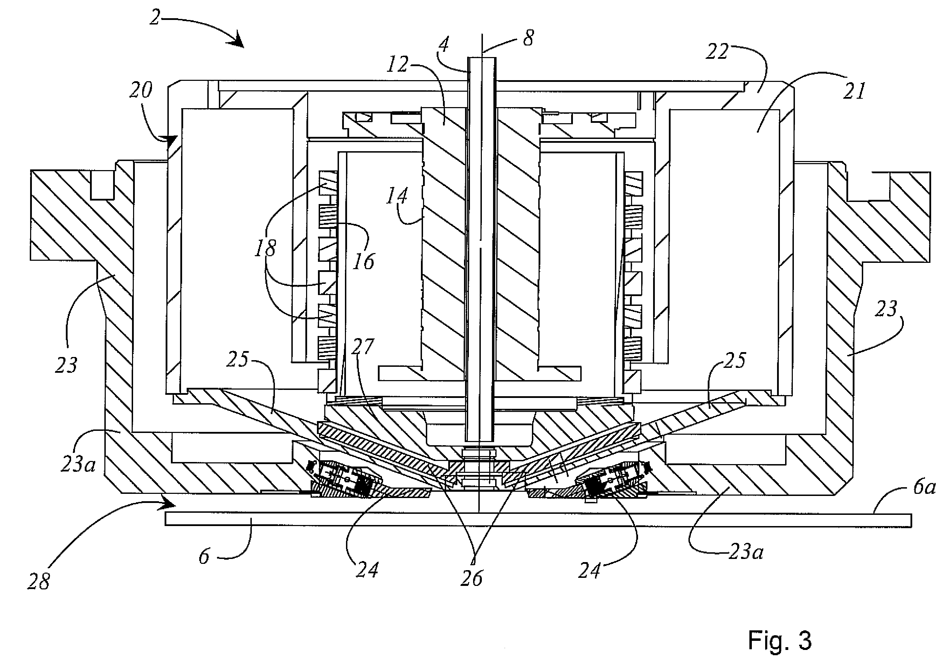

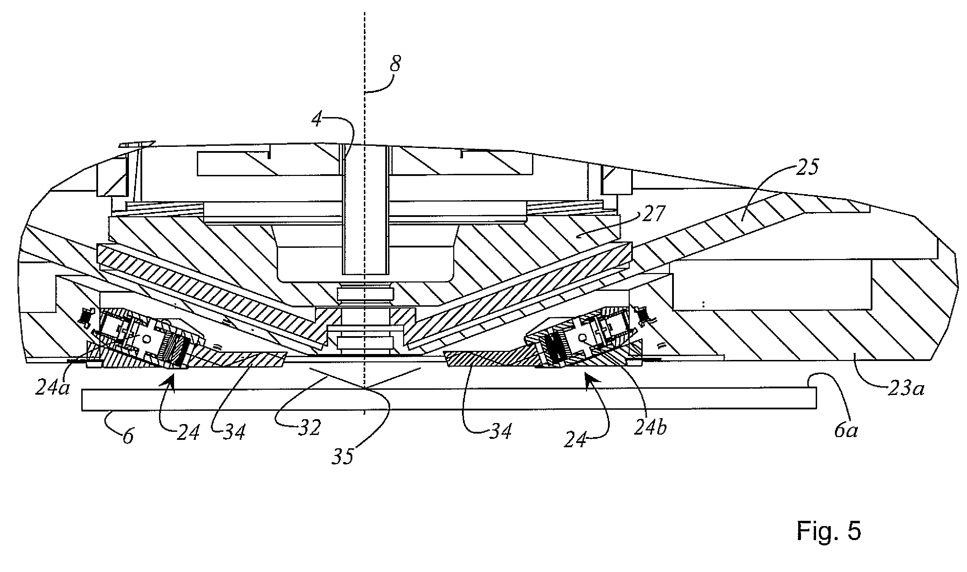

Fig. 3 zeigt eine Detailansicht der Ausgestaltung einer erfindungsgemäßen Objektivlinse 2. Die Objektivlinse 2 ist dabei derart ausgestaltet, dass ein geringer Arbeitsabstand zwischen der Objektivlinse und der Oberfläche 6a des Wafers 6 oder des Substrats erzielt wird. Dabei ist es erforderlich, dass die Stärke des magnetischen Feldes im Bereich der Oberfläche 6a des Wafers 6 gering bzw. veränderbar ist. Die Objektivlinse umfasst ein Vakuumrohr 4, im dem der Elektronenstrahl 8 geführt ist. Das Vakuumrohr 4 ist von einem Ablenksystem 12 umgeben, das auf einem Keramikkörper 14 gehaltert ist. Der Keramikkörper 14 ist von einer Hülse 16 umgeben, die mehrere Ferritringe 18 trägt. Die Ferritringe 18 dienen zur Abschirmung der magnetischen Feldstärke des Ablenksystems 12. Die Ferritringe 18 und somit auch das Vakuumrohr 4 sind von Luft umgeben. Das Objektivlinsensystem 20 umfasst eine Linsenwicklung 21 und einen Eisenkreis 22, in dem die Magnetfeldlinien geführt sind. Die gesamte Objektivlinse 2 ist in einem Stützzylinder 23 gehaltert, der vorzugsweise aus einem kohlenstoffhaltigen Stahl gefertigt ist. Am Stützzylinder 23 ist ein Messsystem gehaltert, mit dem die relative Höhenlage der Oberfläche 6a des Wafers 6 vermessen werden kann (Detailansicht des Messsystems siehe Fig. 5). Die Höhenlage des Wafers 6 wird optisch bestimmt. Der Eisenkreis 22 trägt einen unteren Polschuh 25, der konisch ausgebildet ist. In der hier beschriebenen Ausführungsform trägt der untere Polschuh 25 ein Ferritelement 26, das wiederum zur Abschirmung des magnetischen Feldes des Ablenksystems 12 dient. Ein Keramikbauteil 27 sorgt in dieser Ausführungsform für eine der Abdichtung zwischen der Probenkammer 28 und dem mit Luft gefüllten inneren Linsenraum der Linsenwicklung 21. Der untere Teil 23a des Stützzylinders 23 ist als Temperierplatte 23a ausgebildet, die den geladenen Partikelstrahl bzw. Elektronenstrahl konzentrisch umgibt. Der untere Teil 23a des Stützzylinders 23 liegt der Oberfläche 6a des Wafers 6 gegenüber.

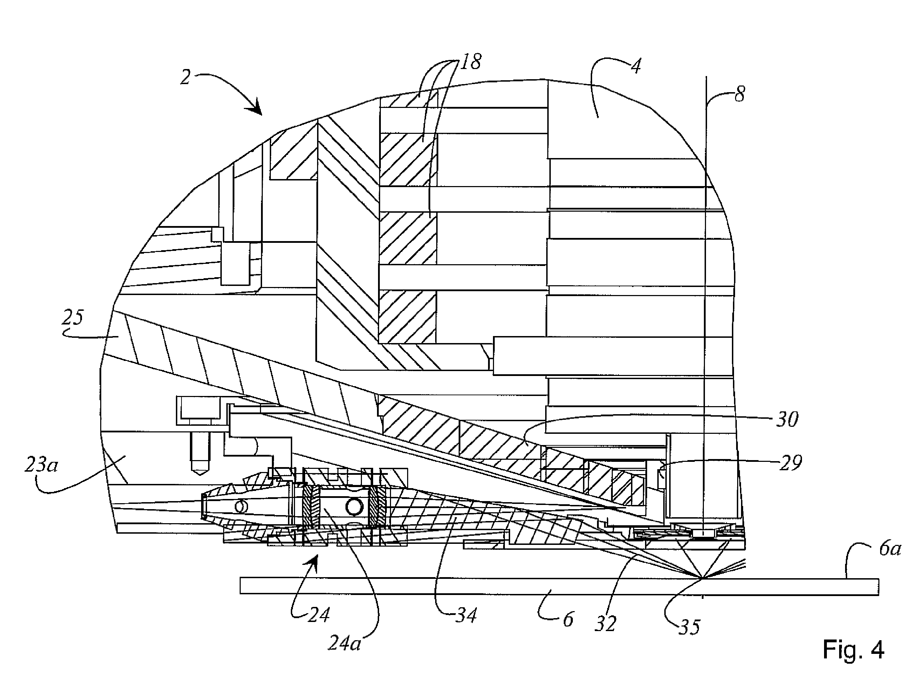

Fig. 4 zeigt eine Detailansicht einer Ausführungsform der Objektivlinse 2, bei der die Abdichtung durch ein am unteren Polschuh 25 vorgesehenes Element 30 erfolgt. Das Element 30 ist dabei aus einem nicht - leitenden, nicht - magnetischen Material hergestellt. Das Element 30 kann z.B. aus einer Keramik oder Glas hergestellt sein. Zwischen dem Element 30 und dem Vakuumrohr 4 ist ein Dichtring 29 vorgesehen, der somit die Vakuumdichtigkeit ermöglicht. Dadurch kann ein geringer Arbeitsabstand zwischen dem unteren Polschuh 25 und der Oberfläche 6a des Wafers 6 realisiert werden. Die elektronenoptischen Eigenschaften an der Oberfläche 6a des Wafers 6 Substrats können dadurch weiter verbessert werden.

Fig. 5 zeigt eine detaillierte Ansicht der Anordnung des Messsystems 24, das die Höhenlage der Oberfläche 6a des Wafers 6 ermittelt. Das Messsystems 24 ist ein optisches Messsystem und umfasst einen Sender 24a und einen Empfänger 24b. Der Sender 24a ist eine Laserdiode, die einen feinen Laserstrahl 32 aussendet. Der Empfänger 24b ist ein lichtempfindlicher Detektor, der das von der Oberfläche 6a des Wafers 6 reflektierte Licht bestimmt und daraus die Höhenlage der Oberfläche 6a des Wafers 6 ermittelt. Der Sender 24a und der Empfänger 24b sind an gegenüberliegenden Positionen derart an der Kühlplatte 23a des Stützzylinders 23 angebracht, dass der Abstand der Objektivlinse 2 zur Oberfläche 6a des Wafers 6 klein gehalten werden kann. Der Sender 24a und der Empfänger 24b sind jeweils mit einem optischen Umlenkmittel 34 versehen. Das Umlenkmittel 34 ist dabei derart ausgestaltet, dass es den Lichtstrahl vom Sender 24a bzw. den von der Oberfläche 6a des Wafers 6 reflektierten Lichtstrahl im Innern des Umlenkmittels 34 mindestens einmal reflektiert. Die Ausgestaltung des Umlenkmittels 34 muss derart sein, dass der Auftreffpunkt 35 des Laserstrahls 32 der Höhenmessung mit der elektronenoptischen Achse im Bereich der Oberfläche 6a des Wafers 6 zusammentrifft. Der Auftreffwinkel des Laserstrahls 32, gemessen zur Oberfläche 6a des Wafers 6, sollte zwischen 10° und 30° liegen. Besonders vorteilhaft ist wenn der Winkel 20° beträgt. Der Laserstrahl 32 für die Höhenmessung wird über mindestens eine Reflexion in dem Umlenkmittel, das als Glaskörper ausgebildet ist, zu der Oberfläche 6a des Wafers 6 geführt. In der hier dargestellten Ausführungsform wird der Laserstrahl 32 2-fach im Umlenkmittel reflektiert.

### Bezugszeichenliste:

- 1: Elektronenstrahl
- 2: Objektivlinse
- 4: Vakuumrohr
- 5: Elektronenstrahlsäule
- 6: Wafer
- 7: Elektronenkanone
- 8: Elektronenstrahl
- 9: Kondensorsystem
- 10: Tisch
- 11: Verkleinerungslinse
- 12: Ablenksystem
- 14: Keramikkörper
- 16: Hülse
- 18: Ferritringe
- 20: Objektivlinsensystem
- 21: Linsenwicklung
- 22: Eisenkreis
- 23: Stützzylinder
- 23a: Kühlplatte
- 24: Messsystem
- 24a: Sender
- 24b: Empfänger
- 25: unterer Polschuh
- 26: Ferritelement
- 27: Keramikbauteil
- 28: Probenkammer
- 29: Dichtring
- 30: Element
- 32: Laserstrahl
- 34: Umlenkmittel
- 35: Auftreffpunkt
- 54: Steuerungssystem
- 55: Quellensteuerung
- 56: Kondensorsteuerung
- 57: Linsensteuerung
- 58: Objektivlinsen-Steuerung
- 59: Tischsteuerung

## Patentansprüche

1. Eine Objektivlinse (2) für einen geladenen Partikelstrahl, umfasst ein Ablenksystem (12), das von einem Objektivlinsensystem (20) umgeben ist, wobei das Objektivlinsensystem (20) aus einer Linsenwicklung (21) und einem Eisenkreis (22) besteht, dass der Eisenkreis (22) einen unteren Polschuh (25) trägt, der konisch ausgebildet ist und gegenüber einer Oberfläche (6a) des Wafers (6) vorgesehen ist, und dass ein Stützzylinder (23) das Objektivlinsensystem (20) umgibt, **dadurch gekennzeichnet, dass** der Stützzylinder einen unteren Abschnitt (23a) ausgebildet hat, der der Oberfläche (6a) des Wafers (6) gegenüber liegt, und dass der untere Abschnitt (23a) ein Messsystem (24) zur Bestimmung der Höhenlage der Oberfläche (6a) des Wafers (6) trägt.

2. Objektivlinse nach Anspruch 1, **dadurch gekennzeichnet, dass** das Messsystem (24) ein optisches Messsystem ist.

3. Objektivlinse nach einem der Ansprüche 1 bis 2, **dadurch gekennzeichnet, dass** Messsystem (24) einen Sender (24a) und einen Empfänger (24b) umfasst, und dass der Sender (24a) und der Empfänger (24b) jeweils mit einem optischen Umlenkmittel (34) versehen sind.

4. Objektivlinse nach Anspruch 1, **dadurch gekennzeichnet, dass** der Sender (24a) eine Laserdiode, die einen feinen Laserstrahl (32) aussendet.

5. Objektivlinse nach Anspruch 4, **dadurch gekennzeichnet, dass** der Sender (24a) und der Empfänger (24b) jeweils mit einem optischen Umlenkmittel (34) versehen, und dass der Lichtstrahl vom Sender (24a) bzw. den von der Oberfläche (6a) des Wafers (6) reflektierten Lichtstrahl im Innern des optischen Umlenkmittels (34) mindestens einmal reflektiert.

6. Objektivlinse nach Anspruch 5, **dadurch gekennzeichnet, dass** das Umlenkmittel (34) derart ausgestaltet ist, dass ein Auftreffpunkt (35) des Laserstrahls (32) der Höhenmessung mit einer elektronenoptischen Achse (4) im Bereich der Oberfläche (6a) des Wafers (6) zusammentrifft.

7. Objektivlinse nach Anspruch 6, **dadurch gekennzeichnet, dass** der Laserstrahl (32) zwischen der Oberfläche (6a) des Wafers (6) einen Winkel zwischen 10° und 30° einschließt.

8. Objektivlinse nach Anspruch 7, **dadurch gekennzeichnet, dass** der Winkel 20° beträgt.

9. Objektivlinse nach einem der Ansprüche 1 bis 8, **dadurch gekennzeichnet, dass** der untere Abschnitt (23a) des Stützzylinders (23) als Temperierplatte ausgebildet ist, die den Partikelstrahl (4) konzentrisch umgibt.

10. Objektivlinse nach einem der Ansprüche 1 bis 9, **dadurch gekennzeichnet, dass** der untere Polschuh (25) konisch ausgebildet ist und ein Ferritelement (26) trägt

11. Objektivlinse nach Anspruch 10, **dadurch gekennzeichnet, dass** ein Keramikbauteil (27) vorgesehen ist, das für eine der Abdichtung zwischen einer Probenkammer (28) und einem mit Luft gefüllten inneren Linsenraum der Linsenwicklung (21) sorgt.

12. Objektivlinse nach Anspruch 1, **dadurch gekennzeichnet, dass** der untere Polschuh (25) konisch ausgebildet ist und eine Element (30) trägt, das aus einem nicht - leitenden, nicht - magnetischen Material besteht.

13. Objektivlinse nach Anspruch 12, **dadurch gekennzeichnet, dass** das Element (30) aus einer Keramik oder Glas hergestellt ist.

14. Objektivlinse nach Anspruch 12, **dadurch gekennzeichnet, dass** zwischen dem Element (30) und einem Vakuumrohr (4), in dem der Partikelstrahl geführt ist, ein Dichtring (29) vorgesehen ist, der für die Vakuumdichtigkeit sorgt.

15. Objektivlinse nach einem der vorangehenden Ansprüche 1 bis 14, **dadurch gekennzeichnet, dass** die Objektivlinse (2) in einer Elektronenstrahllithographiemaschine Verwendung findet.
